(19) Europäisches Patentamt
European Patent Office
Office européen des brevets

(11) EP 3 179 528 B1

(12) # EUROPEAN PATENT SPECIFICATION

(45) Date of publication and mention of the grant of the patent:
**16.02.2022 Bulletin 2022/07**

(21) Application number: **16181485.0**

(22) Date of filing: **27.07.2016**

(51) International Patent Classification (IPC):
***H01L 51/50*** *(2006.01)*

(52) Cooperative Patent Classification (CPC):
**H01L 51/504; H01L 51/506; H01L 51/5088;**
H01L 51/0052; H01L 51/0054; H01L 51/0059

(54) **ORGANIC LIGHT EMITTING DISPLAY APPARATUS**

ORGANISCHE LICHTEMITTIERENDE ANZEIGEVORRICHTUNG

APPAREIL D'AFFICHAGE ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.12.2015 KR 20150173114**

(43) Date of publication of application:
**14.06.2017 Bulletin 2017/24**

(73) Proprietor: **LG Display Co., Ltd.**
**Yeongdeungpo-gu**
**Seoul, 07336 (KR)**

(72) Inventors:
- **KIM, DongHyuk**
  **05834 Seoul (KR)**
- **KAM, Younseok**
  **07531 Seoul (KR)**
- **KIM, Taeshick**
  **446-732 Yongin-si, Gyeonggi-do (KR)**
- **KIM, Seung**
  **131-120 Seoul (KR)**
- **LIM, TaeSeok**
  **139-782 Seoul (KR)**

(74) Representative: **Ter Meer Steinmeister & Partner**
**Patentanwälte mbB**
**Nymphenburger Straße 4**
**80335 München (DE)**

(56) References cited:
**EP-A2- 2 204 862**
**KR-B1- 100 685 971**
**US-A1- 2011 024 726**
**US-A1- 2015 236 261**
**US-A1- 2015 270 500**

- **SUNG HYUN KIM ET AL: "Origin of colour stability in blue/orange/blue stacked phosphorescent white organic light-emitting diodes", JOURNAL OF PHYSICS D: APPLIED PHYSICS, INSTITUTE OF PHYSICS PUBLISHING LTD, GB, vol. 42, no. 1, 7 January 2009 (2009-01-07), page 15104, XP020149003, ISSN: 0022-3727, DOI: 10.1088/0022-3727/42/1/015104**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 179 528 B1

**Description**

## CROSS REFERENCE TO RELATED APPLICATIONS

This application claims the priority benefit of the Korean Patent Application No. 10-2015-0173114 filed on December 7, 2015.

## BACKGROUND

### Field of the Disclosure

Embodiments of the present disclosure relate to an organic light emitting display apparatus (OLED apparatus), and more particularly, to an OLED apparatus which is capable of realizing a long lifetime by optimizing each structure of a hole transporting layer and a hole injecting layer included in a stack disposed close to an anode.

### Discussion of the Related Art

An OLED apparatus is a next generation display apparatus having self-luminance properties. In more detail, the OLED apparatus displays images by producing excitons through a recombination of holes and electrons, which are respectively injected from the anode and cathode, in a light emitting layer, and generating light with a specific wavelength by an energy emission of the produced excitons.

Unlike a liquid crystal display apparatus (LCD apparatus), the OLED apparatus does not require an additional light source. Thus, the OLED apparatus is light weight and has a thin profile. In comparison to the LCD apparatus, the OLED apparatus has various advantages with respect to wide viewing angle, good contrast ratio, rapid response speed and low power consumption, whereby the OLED apparatus has attracted great attentions as the next generation display apparatus.

Document EP2204862 (A) discloses an OLED display comprising blue/yellow-green:red/blue emission layers stack.

## SUMMARY

An OLED apparatus having self-luminance properties may include an anode, a cathode, and an emission layer, and may further include organic layers such as an injecting layer and a transporting layer. The properties of the OLED apparatus, for example, driving voltage and lifetime of the OLED apparatus, may be directly influenced by the organic layers of the emission layer, the injecting layer, or the transporting layer. In more detail, a flow of holes and electrons is controlled by the structure of the organic layers disposed between the anode and the cathode, or the material properties of the organic layers disposed between the anode and the cathode, whereby a position of an emission zone, in which a recombination of the holes and the electrons intensively occurs, is changed in accordance with the flow control of the holes and the electrons. This directly affects the property of the OLED apparatus. For example, if the emission zone is positioned on the interface between the emission layer and another organic layer adjacent to the emission layer, the lifetime of the OLED apparatus may be shortened by the interface deterioration.

The present inventors propose a new OLED apparatus which is capable of realizing improved lifetime and driving voltage properties by optimizing a structure of a hole transporting layer and/or a hole injecting layer disposed between two electrodes through various experiments. The objects are achieved by the features of the independent claim. Features of preferred embodiments are set out in the dependent claims.

There is provided an OLED apparatus according to the claims in which a hole transporting layer is formed in a mixed structure including two materials having the different hole mobilities, and in which a charge balance of an organic light emitting element is improved by adjusting a weight ratio of an organic material to an inorganic material included in a hole injecting layer, to thereby realize the improved lifetime and progressive driving voltage properties.

It is to be understood that both the foregoing general description and the following detailed description of embodiments of the present disclosure are exemplary and explanatory and are intended to provide further explanation of the disclosure as claimed.

According to one embodiment of the present invention, an OLED apparatus according to the claims comprises an anode, a cathode, and a plurality of stacks, wherein, among the plurality of stacks, the first stack closest the anode includes a first emission layer including a blue emission layer; and a hole transporting layer having a first material, and a second material whose hole mobility is smaller than that of the first material.

According to one embodiment of the present invention, an OLED apparatus according to the claims comprises a blue emission layer, a hole transporting layer, and a hole injecting layer between an anode and a cathode, wherein

the hole transporting layer is formed in a mixed structure having two materials with the different hole mobilities, and the hole injecting layer includes an organic material and an inorganic material, and, on assumption that a weight of the inorganic material included in the hole injecting layer is 'A', and a weight of the organic material included in the hole injecting layer is 'B', 'A' and 'B' satisfy one of the following Equations (1) to (3):

$$\text{[Equation (1)]} \quad B>A \text{ and } A\geq 2/3\times B,$$

$$\text{[Equation (2)]} \quad A>B \text{ and } B\geq 2/3\times A,$$

and

$$\text{[Equation (3)]} \quad A=B.$$

## BRIEF DESCRIPTION OF THE DRAWINGS

The accompanying drawings, which are included to provide a further understanding of embodiments of the disclosure and are incorporated in and constitute a part of this application, illustrate embodiment(s) of the disclosure and together with the description serve to explain the principle of embodiments of the disclosure. In the drawings:

FIG. 1 is a cross sectional view illustrating an OLED apparatus according to one embodiment of the present disclosure;
FIG. 2 is a cross sectional view illustrating the components of the OLED apparatus according to one embodiment of the present disclosure;
FIG. 3A is a graph showing a lifetime of the OLED apparatus in accordance with a weight ratio of a first material to a second material included in a hole transporting layer;
FIG. 3B is a graph showing a progressive driving voltage of the OLED apparatus in accordance with a weight ratio of a first material to a second material included in a hole transporting layer;
FIG. 4A is a graph showing a lifetime of the OLED apparatus in accordance with a weight ratio of an organic material to an inorganic material included in a hole injecting layer;
FIG. 4B is a graph showing a progressive driving voltage of the OLED apparatus in accordance with a weight ratio of an organic material to an inorganic material included in a hole injecting layer; and
FIG. 5 is another graph showing a lifetime of the OLED apparatus in accordance with a weight ratio of an organic material to an inorganic material included in a hole injecting layer.

## DETAILED DESCRIPTION OF THE EMBODIMENTS

Reference will now be made in detail to the exemplary embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings.

Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In description of embodiments of the present disclosure, when a structure (for example, an electrode, a line, a wiring, a layer, or a contact) is described as being formed at an upper portion/lower portion of another structure or on/under the other structure, this description should be construed as including a case where the structures contact each other and moreover, a case where a third structure is disposed therebetween.

In describing a time relationship, for example, when the temporal order is described as 'after~', 'subsequent~',

'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

For convenience of explanation, a size and thickness of each element are shown as exemplary in the drawings, but are not limited to the shown size and thickness.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, an organic light emitting display apparatus (OLED apparatus) according to embodiments of the present disclosure will be described in detail with reference to the accompanying drawings including FIG. 1 to FIG. 5.

FIG. 1 is a cross sectional view illustrating an OLED apparatus 1000 according to one embodiment of the present disclosure. All the components of the OLED apparatus according to all embodiments of the present disclosure are operatively coupled and configured.

Referring to FIG. 1, the OLED apparatus 1000 may include a substrate 100, a thin film transistor 300, and an organic light-emitting element (ED). The OLED apparatus 1000 may include a plurality of pixels (P). The pixel (P) indicates a minimum unit for emitting light, which may also be referred to as a sub-pixel or a pixel region. Also, the plurality of pixels (P) or sub-pixels may constitute one group for expressing white light. For example, a red pixel, a green pixel, and a blue pixel may constitute one group, or a red pixel, a green pixel, a blue pixel, and a white pixel may constitute one group. However, it is not limited to this structure, that is, various pixel designs are possible. For convenience of explanation, FIG. 1 shows only one pixel (P).

The thin film transistor 300 is disposed on the substrate 100, and the thin film transistor 300 supplies various signals to the organic light-emitting element (ED). The thin film transistor 300 shown in FIG. 1 may be a driving thin film transistor connected with an anode 400 of the organic light-emitting element (ED). Additionally, a switching thin film transistor or a capacitor for driving the organic light-emitting element (ED) may be disposed on the substrate 100.

The substrate 100 is formed of an insulating material. For example, the substrate 100 may be formed of a flexible film of glass or a polyimide-based material.

The thin film transistor 300 may include a gate electrode 310, an active layer 320, a source electrode 330, and a drain electrode 340. Referring to FIG. 1, the gate electrode 310 is disposed on the substrate 100, and a gate insulating layer 210 covers the gate electrode 310. Also, the active layer 320 is disposed on the gate insulating layer 210, and is overlapped with the gate electrode 310. The source electrode 330 and the drain electrode 340 are disposed on the active layer 320, and the source electrode 330 and the drain electrode 340 are spaced apart from each other.

The gate electrode 310, the source electrode 330, and the drain electrode 340 are formed of a conductive material, for example, molybdenum (Mo), aluminum (Al), chrome (Cr), gold (Au), titanium (Ti), nickel (Ni), neodymium (Nd), copper (Cu), and their alloys, but are not limited to these materials.

According to the type, the active layer 320 may be formed of any one of amorphous silicon (a-Si), polycrystalline silicon (poly-Si), oxide, and organic materials, but is not limited to these materials.

The gate insulating layer 210 may be formed in a singular-layered structure or multi-layered structure of inorganic material, for example, silicon oxide (SiOx), silicon nitride (SiNx), etc.

FIG. 1 shows the thin film transistor 300 having a staggered structure, but the thin film transistor 300 is not limited to this structure. For instance, the thin film transistor 300 may have a coplanar structure instead of the staggered structure.

A planarization layer 220 for exposing a predetermined portion of the source electrode 330 is disposed on the thin film transistor 300. The planarization layer 220 may have a singular-layered structure or multi-layered structure, and the planarization layer 220 may be formed of an organic material. For example, the planarization layer 220 may be formed of polyimide, acryl, etc.

A passivation layer may be additionally provided between the planarization layer 220 and the thin film transistor 300. The passivation layer is formed of an inorganic material. The passivation layer protects the thin film transistor 300. Like the planarization layer 220, the passivation layer may expose a predetermined portion of the source electrode 330.

The organic light-emitting element (ED) is disposed on the planarization layer 220, wherein the organic light-emitting element (ED) includes the anode 400, a light-emitting unit 500, and a cathode 600. The anode 400 of the organic light-emitting element (ED) is connected with the source electrode 330 of the thin film transistor 300, and various signals are supplied to the anode 400 of the organic light-emitting element (ED) through the thin film transistor 300. According to the type of the thin film transistor 300, the anode 400 may be connected with the drain electrode 340 of the thin film transistor 300.

If the OLED apparatus 1000 of FIG. 1 is a top emission type, light emitted from the light-emitting unit 500 may

advance to an upper direction through the cathode 600. If the OLED apparatus 1000 of FIG. 1 is a bottom emission type, light emitted from the light-emitting unit 500 may advance to a lower direction through the anode 400. In this case, in order to avoid obstructing a path of the light emitted from the light-emitting unit 500, the thin film transistor 300 may be disposed in an area which is not overlapped with the anode 400 or an area which is overlapped with a bank 230.

The bank 230 is disposed between the neighboring pixels (P), and the bank 230 covers an end of the anode 400. Referring to FIG. 1, the bank 230 exposes a predetermined portion of an upper surface of the anode 400. The bank 230 may be formed of an organic material, for example, any one of polyimide and photoacryl, but is not limited to these materials.

FIG. 2 is a cross sectional view illustrating the components of the OLED apparatus 1000 according to one embodiment of the present disclosure, which is a cross sectional view for explaining a stack structure of the plurality of light-emitting elements (ED) of the OLED apparatus 1000.

Referring to FIG. 2, the organic light-emitting element (ED) of the OLED apparatus 1000 includes the anode 400, the cathode 600, and the light-emitting unit 500 disposed between the anode 400 and the cathode 600. The light-emitting unit 500 indicates all organic layers disposed between the anode 400 and the cathode 600, or a stack structure of all organic layers disposed between the anode 400 and the cathode 600. For example, as shown in FIG. 2, the light-emitting unit 500 may be formed in a sequential stack structure of a first stack 510 including a hole injecting layer 511, a first hole transporting layer 512, a first emission layer 513 and a first electron transporting layer 514, a second stack 520 including a second hole transporting layer 522, a second emission layer 523 and a second electron transporting layer 524, and a third stack 530 including a third hole transporting layer 532, a third emission layer 533 and a third electron transporting layer 534.

The light-emitting unit 500 of the OLED apparatus 1000 according to one embodiment of the present disclosure shown in FIG. 2 has a common emission layer structure, and emits the white light. The light-emitting unit 500 with the common emission layer structure may be formed by the use of a common mask with open areas corresponding to all pixels (P). The light-emitting unit 500 may be deposited in the same structure for all pixels (P) without an individual pattern every pixel (P). That is, the light-emitting unit 500 of the common emission layer structure is connected or disposed without disconnection from one pixel (P) to the neighboring pixel (P) so that the light-emitting unit 500 is shared by the plurality of pixels (P). Also, the light emitted from the plurality of emission layers 513, 523 and 533 included in the light-emitting unit 500 may be mixed together, whereby the white light may be emitted through the anode 400 or cathode 600 from the light-emitting unit 500.

The anode 400 is separately disposed for each pixel (P). The anode 400 is an electrode for supplying or transmitting holes to the light-emitting unit 500, and the anode 400 is connected with the source electrode 330 or drain electrode 340 of the thin film transistor 300. The anode 400 may be formed of a transparent layer of TCO (transparent conductive oxide) material such as ITO (indium tin oxide ) or IZO (indium zinc oxide).

If the OLED apparatus 1000 according to one embodiment of the present disclosure is the top emission type, the anode 400 may further include a reflection layer for smoothly reflecting the light emitted from the light-emitting unit 500 to an upper direction. For example, the anode 400 may be formed in a dual-layered structure including a transparent layer and a reflection layer deposited in sequence, or a three-layered structure including a transparent layer, a reflection layer and another transparent layer deposited in sequence. Herein, the reflection layer may be formed of a metal material such as copper (Cu), silver (Ag), palladium (Pd), etc.

The cathode 600 is disposed on the light-emitting unit 500, wherein the cathode 600 is an electrode for supplying or transmitting electrons to the light-emitting unit 500. The cathode 600 may be formed of a metal material such as silver (Ag), magnesium

(Mg), silver-magnesium (Ag-Mg), etc., or TCO (transparent conductive oxide) material such as ITO (indium tin oxide) or IZO (indium zinc oxide).

The light-emitting unit 500 disposed between the anode 400 and the cathode 600 includes the plurality of stacks 510, 520 and 530, and the first and second charge generation layers 540 and 550 disposed in-between the stacks 510, 520 and 530.

Among the plurality of stacks 510, 520 and 530, the first stack 510 is disposed closest to the anode 400. The first stack 510 includes the hole injecting layer 511, the first hole transporting layer 512, the first emission layer 513, and the first electron transporting layer 514. The second stack 520 is disposed between the first stack 510 and the cathode 600. The second stack 520 includes the second hole transporting layer 522, the second emission layer 523, and the second electron transporting layer 524. The third stack 530 is disposed between the second stack 520 and the cathode 600. The third stack 530 includes the third hole transporting layer 532, the third emission layer 533, and the third electron transporting layer 534.

The light emitted from each of the plurality of emission layers 513, 523, and 533 included in the light-emitting unit 500 may be mixed together, whereby white light may be emitted. This will be described in detail as follows.

The first emission layer 513 consists of a blue emission layer having at least one host and dopant for emitting blue light. In this case, a peak wavelength of the light emitted from the first stack 510 may be within a range from 430nm

to 480nm.

The second emission layer 523 may include a yellow-green emission layer having at least one host and dopant for emitting yellow-green light, or a green emission layer having at least one host and dopant for emitting green light. In this case, a peak wavelength of the light emitting from the second stack 520 may be within a range from 510nm to 580nm.

The second emission layer 523 may further include a red emission layer having at least one host and dopant for emitting red light. In this case, a peak wavelength of the light emitting from the second stack 520 may be within a range from 5 10nm to 650nm.

The third emission layer 533 consists of a blue emission layer having at least one host and dopant for emitting blue light. In this case, a peak wavelength of the light emitting from the third stack 530 may be within a range from 430nm to 480nm.

The hole injecting layer 511 is provided for a smooth injection of holes from the anode 400.

The first hole transporting layer 512, the second hole transporting layer 522, and the third hole transporting layer 532 are provided to smoothly transfer the holes, which are supplied or transmitted from the anode 400 or charge generation layers 540 and 550, to the emission layers 513, 523, and 533.

Each of the first hole transporting layer 512, the second hole transporting layer 522, and the third hole transporting layer 532 has a thickness enabling to optimize a micro-cavity of the light emitted from each of the emission layers 513, 523, and 533 by a distance between the anode 400 and the cathode 600. Herein, the micro-cavity indicates that light-emission efficiency is improved by amplification and constructive interference of the light with a specific wavelength through repetitive reflection and re-reflection of the light emitted from the emission layer between the two electrodes 400 and 600. For example, in order to optimize the micro-cavity of the light emitted from the first emission layer 513 by the distance between the two electrodes 400 and 600, the first hole transporting layer 512 may have the thickness from about 900Å to 1100Å. Also, in order to optimize the micro-cavity of the light emitted from the second emission layer 523 by the distance between the two electrodes 400 and 600, the second hole transporting layer 522 may have the thickness of about 100Å or less than about 100Å. Also, in order to optimize the micro-cavity of the light emitted from the third emission layer 533 by the distance between the two electrodes 400 and 600, the third hole transporting layer 532 may have the thickness from about 800Å to 1000Å.

The first electron transporting layer 514, the second electron transporting layer 524, and the third electron transporting layer 534 are provided to smoothly transfer the electrons, which are supplied or transmitted from the cathode 600 or the charge generation layers 540 and 550, to the emission layers 513, 523, and 533.

The first charge generation layer 540 is disposed between the first stack 510 and the second stack 520, and the second charge generation layer 550 is disposed between the second stack 520 and the third stack 530. The first charge generation layer 540 and the second charge generation layer 550 are provided to inject the electrons and the holes to the first emission layer 513, the second emission layer 523, or the third emission layer 533. Each of the first charge generation layer 540 and the second charge generation layer 550 may be formed in the structure including N-type charge generation layer and P-type charge generation layer connected with each other. In this case, the N-type charge generation layer supplies the electrons to the emission layer disposed close to the anode 400, for example, the first emission layer 513 or the second emission layer 523. Also, the P-type charge generation layer supplies the holes to the emission layer disposed close to the cathode 600, for example, the second emission layer 523 and the third emission layer 533. Accordingly, the light-emission efficiency of the OLED apparatus 1000 including the plurality of emission layers 513, 523, and 533 is improved, and the driving voltage thereof is lowered.

As described above, the property of the OLED apparatus 1000 may be determined based on the structure of the organic layers included in the light-emitting unit 500 or the material property of the organic layers included in the light-emitting unit 500. In detail, a position of an emission zone, in which a recombination of the holes and the electrons intensively occurs, is changed in accordance with a flow control of the holes and the electrons in the light-emitting unit 500 by the structure of the organic layers included in the light-emitting unit 500 or the material property of the organic layers included in the light-emitting unit 500. This directly affects the property of the OLED apparatus 1000.

Through various experiments, the inventors of the present disclosure propose and invented the optimal structure of the hole injecting layer 511 and the first hole transporting layer 512 included in the stack 510 so as to optimize a balance of the holes and the electrons in the first stack 510 so that it is possible to realize the OLED apparatus 1000 by improving lifetime of the blue light emitted from the first stack 510 and minimizing the change of driving voltage of the organic light-emitting element (ED) in accordance with time. This will be described in detail as follows.

The first hole transporting layer 512 included in the first stack 510 according to one embodiment of the present disclosure is formed in a mixed structure including two materials with the different hole mobilities. In detail, the first hole transporting layer 512 has the mixed structure including a first material, and a second material whose hole mobility is smaller than that of the first material.

The first material included in the first hole transporting layer 512 of the mixed structure may be the material whose mobility is relatively larger than that of the second material, and the first material may be formed of an organic material having a hole mobility within a range from $5.0\times10\text{-}5\ cm^2/V\cdot S$ to $9.0\times10\text{-}4\ cm^2/V\cdot S$. Preferably, the first material

may include any one among α-NPD(N,N'-bis(naphthalene-1-yl)-N,N'-bis(phenyl)-2,2'-dimethylbenzidine), TCTA(4,4',4"-tris(carbazol-9-yl)triphenylamine), TPD(N,N'-bis(3-methylpneyl)-N,N'-bis(phenyl)-benzidine), TRP, OPT1, m-TPEE, TPB(tetra-N-phenylbenzidine), FTPD(fluorinatedtriphenyldiamine), PPD(p-phenylenediamine), TPAC(1,1-bis(4-di-p-tolylaminophenyl)-cyclohexane), and (NDA)PP((naphthalenedicarboxylate)phenylphenantrisinering).

Herein, 'm-TPEE' may be a compound expressed by the following Chemical Formula 1.

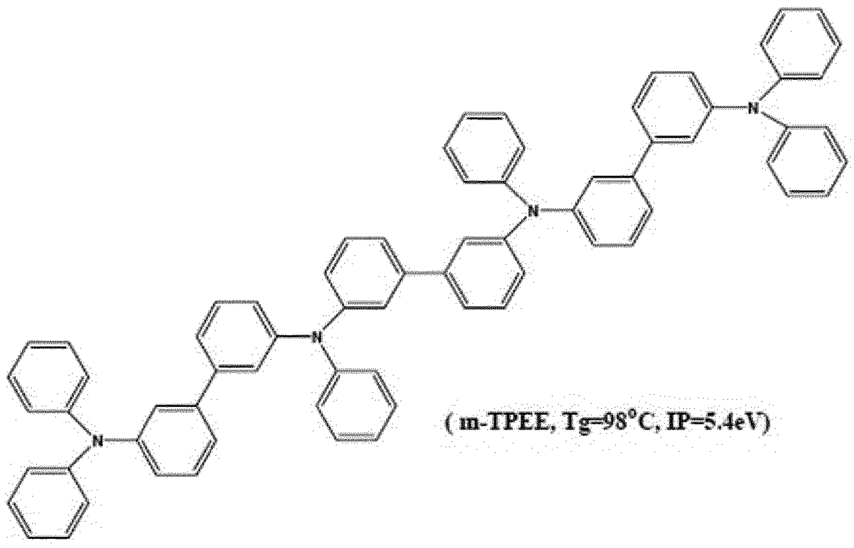

( m-TPEE, Tg=98°C, IP=5.4eV)

.......Chemical Formula 1

Herein, 'TRP' may be a compound expressed by the following Chemical Formula 2.

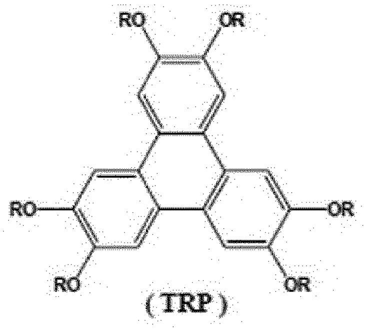

( TRP )

.....................................................................Chemical Formula 2

Herein, 'OPT1' may be a compound expressed by the following Chemical Formula 3.

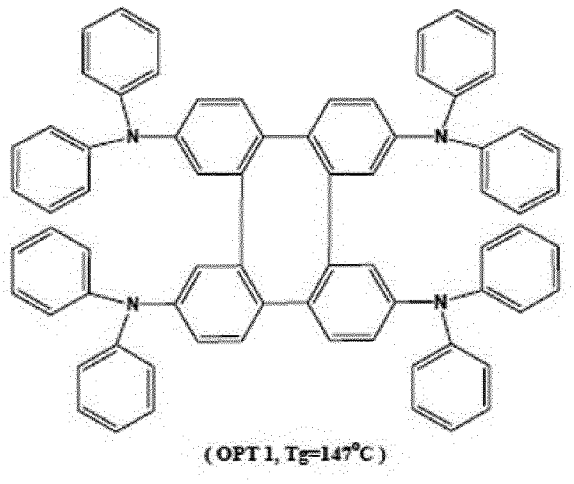

( OPT 1, Tg=147°C )

........................................Chemical Formula 3

However, if the first hole transporting layer 512 is formed only of the material with the large hole mobility, the balance of the holes and the electrons injected into the light-emitting unit 500 is not maintained so that the lifetime property of the OLED apparatus 1000 is lowered. In detail, if the first hole transporting layer 512 is formed in a single structure having only the first material with the large hole mobility, the amount of holes injected into the first emission layer 513 is excessively large in comparison to the amount of electrons injected into the first emission layer 513, whereby the emission zone, in which the recombination of the holes and the electrons occurs intensively, is positioned on the interface between the first emission layer 513 and the first electron transporting layer 514, or adjacent to the interface between the first emission layer 513 and the first electron transporting layer 514. In this case, deterioration may occur on the interface between the first emission layer 513 and the first electron transporting layer 514, or adjacent to the interface between the first emission layer 513 and the first electron transporting layer 514, whereby the lifetime of light emitted from the first stack 510 of the OLED apparatus 1000 may be lowered.

The first hole transporting layer 512 according to one embodiment of the present disclosure is formed in the mixed structure including the first material, and the second material whose hole mobility is relatively smaller than that of the first material. Thus, the balance of the holes and the electrons in the first emission layer 513 is maintained so that the deterioration is reduced on the interface between the first emission layer 513 and the first electron transporting layer 514 or adjacent to the interface between the first emission layer 513 and the first electron transporting layer 514. Accordingly, it is possible to prevent the lifetime of light emitted from the first stack 510 positioned close to the anode 400 from being lowered.

The second material of the first hole transporting layer 512 according to one embodiment of the present disclosure may be formed of an organic material having a hole mobility within a range from 5.0×10-6 $cm^2/V \cdot S$ to 5.0×10-5 $cm^2/V \cdot S$. The hole mobility of the second material may have the value corresponding to 1 / 10 of the hole mobility of the first material or less than 1 / 10 of the hole mobility of the first material. The second material is an organic compound including spirofluorene group. If the hole mobility of the second material has the value which is more than 1 / 10 of the hole mobility of the first material, a supply of the holes to the first emission layer 513 is not reduced to a level enabling the emission zone to be sufficiently apart from the interface between the first emission layer 513 and the first electron transporting layer 514, whereby the lifetime of light emitted from the first stack 510 is lowered.

In case of one embodiment of the present disclosure, on assumption that the weight total of the first material and the second material of the first hole transporting layer 512 is 100wt%, a weight of the first material may be larger than a weight of the second material. More preferably, on assumption that the weight total of the first material and the second material of the first hole transporting layer 512 is 100wt%, a weight ratio of the first material to the second material may be within a range from 80wt% : 20wt% to 90wt% : 10wt%. In other words, on assumption that the weight total of the first material and the second material of the first hole transporting layer 512 is 100wt%, the first material is within a range from 80wt% to 90wt%, and the second material is within a range from 10wt% to 20wt%. If the amount of second material is excessively large in the first hole transporting layer 512, a hole trap may be generated between the first material and the second material by the mixture of the different materials, thereby lowering an efficiency in hole mobility to the first emission layer 513. Accordingly, the driving voltage of the OLED apparatus 1000 is raised in accordance with the lapse of time.

In the OLED apparatus 1000 according to one embodiment of the present disclosure, a flow of the holes and electrons in the first emission layer 513 is optimized by adjusting the hole mobility of the first material of the first hole transporting layer 512, the hole mobility of the second material of the first hole transporting layer 512, and the weight ratio of the first material to the second material so that it is possible to improve the lifetime of light emitted from the first stack 510 of the OLED apparatus 1000, and to minimize the change of driving voltage in accordance with the lapse of time, that is, the increase of progressive driving voltage.

In the OLED apparatus 1000 according to one embodiment of the present disclosure, as shown in FIG. 2, the hole injecting layer 511 may be additionally disposed between the first hole transporting layer 512 and the anode 400 so as to maintain a charge balance in the first emission layer 513. The hole injecting layer 511 is provided to smoothly inject the holes supplied from the anode 400, whereby the hole injecting layer 511 is disposed in contact with the anode 400. That is, according as the anode 400, the hole injecting layer 511, the first hole transporting layer 512, and the first emission layer 513 are provided in the sequential contact structure, whereby the holes supplied from the anode 400 is smoothly transferred to the first emission layer 513.

If the first hole transporting layer 512 according to one embodiment of the present disclosure is formed in the mixed structure including the two materials with different hole mobilities, the hole injecting layer 511 may be formed of a mixed-structure layer of an organic material and an inorganic material. For example, the hole injecting layer 511 may be formed of the mixed-structure layer having magnesium fluoride ($MgF_2$) of the inorganic material and rubrene of the organic material. As described above, the hole injecting layer 511 is disposed in contact with the anode 400, and the hole injecting layer 511 is provided to smoothly transfer the holes between the anode 400 and the first hole transporting layer 512. In order to smoothly inject the holes supplied from the anode 400, it is necessary to adjust the energy level and hole mobility between the anode 400 and the hole injecting layer 511. If the hole injecting layer 511 is formed only

of the organic material, for example, rubrene, an energy level of the hole injecting layer 511 is high in comparison to the anode 400 so that the holes are accumulated on the interface between the anode 400 and the hole injecting layer 511, thereby causing a deterioration. Also, if the hole injecting layer 511 is formed only of the inorganic material, for example, magnesium fluoride ($MgF_2$), it is possible to decrease an energy level difference between the anode 400 and the hole injecting layer 511. However, according as the hole mobility of the hole injecting layer 511 is excessively lowered, the holes supplied from the anode 400 are not smoothly injected, or the holes injected to the hole injecting layer 511 are not smoothly transferred to the first hole transporting layer 513, whereby the holes are accumulated on the interface between the anode 400 and the hole injecting layer 511, thereby causing a deterioration. In this case, due to a deteriorated capacity in hole mobility from the anode 400 to the first emission layer 513, the lifetime of light emitted from the first stack 510 may be lowered, and the progressive driving voltage of the OLED apparatus 1000 may be raised.

When the hole injecting layer 511 according to one embodiment of the present disclosure includes both inorganic and organic materials, a weight of the inorganic material is ’A’, and a weight of the organic material is ’B’, ’A’ and ’B’ may satisfy one of the following Equations (1) to (3):

$$\text{[Equation (1)]} \qquad B>A \text{ and } A\geq 2/3\times B,$$

$$\text{[Equation (2)]} \qquad A>B \text{ and } B\geq 2/3\times A,$$

and

$$\text{[Equation (3)]} \qquad A=B.$$

On assumption that the total weight of the inorganic material and the organic material included in the hole injecting layer 511 is 100wt%, the organic material is within a range from 40wt% to 60wt%, and the inorganic material is within a range from 40wt% to 60wt%.

If the weight of the organic material or inorganic material of the hole injecting layer 511 is not within the above range, that is, the amount of organic material or inorganic material of the hole injecting layer 511 is excessive, as described above, it may be difficult to optimize the energy level between the anode 400 and the hole injecting layer 511 or the hole mobility of the hole injecting layer 511. That is, in spite of the optimized capacity in hole mobility of the first hole transporting layer 512 having the mixed structure, if the structure of the hole injecting layer 511 being in contact with the first hole transporting layer 512 and the anode 400 is not optimized, it is difficult to maintain the balance of holes and electrons in the first emission layer 513. Accordingly, the lifetime of light emitted from the first stack 510 may be lowered, and the progressive driving voltage of the OLED apparatus 1000 may be raised.

Accordingly, the OLED apparatus 1000 according to one embodiment of the present disclosure is provided with the first hole transporting layer 512 of the mixed structure including the two materials with different hole mobilities, and the hole injecting layer 511 including the organic material and the inorganic material, to thereby maintain the charge balance in the first stack 510. More preferably, the lifetime of light emitted from the first stack 510 is improved, and the change of the driving voltage of the OLED apparatus 1000 in accordance with the lapse of time is minimized by optimizing the weight ratio of the first material to the second material in the first hole transporting layer 512 and optimizing the weight ratio of the organic material to the inorganic material in the hole injecting layer 511.

FIG. 3A is a graph showing the lifetime of the OLED apparatus in accordance with the weight ratio of the first material to the second material in the hole transporting layer. FIG. 3B is a graph showing the progressive driving voltage of the OLED apparatus in accordance with the weight ratio of the first material to the second material in the hole transporting layer. In detail, FIG. 3A is the graph showing the lifetime of blue light emitted from the first stack 510 of the OLED apparatus 1000 in accordance with the weight ratio of the first material to the second material in the first hole transporting layer 512 of the OLED apparatus 1000 described with reference to FIGs. 1 and 2. FIG. 3B is the graph showing the progressive driving voltage of the OLED apparatus 1000 in accordance with the weight ratio of the first material to the second material in the first hole transporting layer 512 of the OLED apparatus 1000 described with reference to FIGs. 1 and 2.

Referring to FIG. 3A, if the first hole transporting layer 512 is formed in the single structure including only the first material (HTL1) with the relatively-large hole mobility, on assumption that an initial luminance (Lo) is 100%, the time consumed until the luminance (L) is reduced to 95% is about 200hrs. Referring to FIG. 3B, if the first hole transporting layer 512 is formed in the single structure including only the first material (HTL1) with the relatively-large hole mobility, the changed amount of driving voltage after 400 hrs from an initial driving voltage, that is, the progressive driving voltage is about 0.4V.

Meanwhile, if the first hole transporting layer 512 is formed in the mixed structure including the first material (HTL1), and the second material (HTL2) whose hole mobility is relatively smaller than that of the first material (HTL1), the time consumed until the luminance (L) is reduced to 95% in the mixed structure is relatively increased in comparison to the time in the single structure, and the progressive driving voltage in the mixed structure is relatively increased in comparison to the progressive driving voltage in the single structure.

In detail, referring to FIG. 3A, if the weight ratio of the first material (HTL1) to the second material (HTL2) in the first hole transporting layer 512 is at 90wt% : 10wt%, the time consumed until the luminance (L) is reduced to 95% in comparison to the initial luminance (Lo) is about 260hrs, that is, it is increased to about 130% in comparison to the single structure of the first hole transporting layer 512. Referring to FIG. 3B, if the weight ratio of the first material (HTL1) to the second material (HTL2) in the first hole transporting layer 512 is at 90wt% : 10wt%, the changed amount of driving voltage after 400hrs from the initial driving voltage, that is, the progressive driving voltage is about 0.5V, which is increased by about 0.1V in comparison to the single structure of the first hole transporting layer 512.

Also, referring to FIG. 3A, if the weight ratio of the first material (HTL1) to the second material (HTL2) in the first hole transporting layer 512 is at 80wt% : 20wt%, the time consumed until the luminance (L) is reduced to 95% in comparison to the initial luminance (Lo) is about 360hrs, that is, it is increased to about 180% in comparison to the single structure of the first hole transporting layer 512. Referring to FIG. 3B, if the weight ratio of the first material (HTL1) to the second material (HTL2) in the first hole transporting layer 512 is at 80wt% : 20wt%, the changed amount of driving voltage after 400hrs from the initial driving voltage, that is, the progressive driving voltage is about 0.6V, that is it is increased by about 0.2V in comparison to the single structure of the first hole transporting layer 512.

Also, referring to FIG. 3A, if the weight ratio of the first material (HTL1) to the second material (HTL2) in the first hole transporting layer 512 is at 70wt% : 30wt%, the time consumed until the luminance (L) is reduced to 95% in comparison to the initial luminance (Lo) is about 390hrs, that is, it is increased to about 195% in comparison to the single structure of the first hole transporting layer 512. Referring to FIG. 3B, if the weight ratio of the first material (HTL1) to the second material (HTL2) in the first hole transporting layer 512 is at 70wt% : 30wt%, the changed amount of driving voltage after 400hrs from the initial driving voltage, that is, the progressive driving voltage is about 0.8V, which is increased by about 0.4V in comparison to the single structure of the first hole transporting layer 512.

That is, referring to FIGs. 3A and 3B, the first hole transporting layer 512 of the OLED apparatus 1000 according to one embodiment of the present disclosure is formed in the mixed structure including the first material (HTL1), and the second material (HTL2) whose hole mobility is relatively smaller than that of the first material (HTL1), whereby it is possible to maintain the balance of holes and electrons in the first emission layer 513 including the blue emission layer, that is, a deterioration is reduced on the interface between the first emission layer 513 and the first electron transporting layer 514 or adjacent to the interface between the first emission layer 513 and the first electron transporting layer 514. Accordingly, in comparison to the single structure of the first hole transporting layer 512 having only the first material (HTL1) with the relatively-large hole mobility, the mixed structure enables to improve the lifetime of blue light emitted from the first stack 510.

However, if the weight of the second material (HTL2) is increased in the first hole transporting layer 512, and more particularly, if the weight of the second material

(HTL2) in the first hole transporting layer 512 is increased to be 30wt% or more than 30wt%, that is, the second material (HTL2) is excessively included in the first hole transporting layer 512, the hole trap may be generated between the first material (HTL1) and the second material (HTL2) by the mixture of the two different materials, thereby lowering the efficiency of hole mobility to the first emission layer 513. Thus, as shown in FIG. 3B, the progressive driving voltage of the OLED apparatus 1000 is largely increased.

Thus, in the OLED apparatus 1000 according to one embodiment of the present disclosure, the first hole transporting layer 512 is formed in the mixed structure including the first material (HTL1), and the second material (HTL2) whose hole mobility is relatively smaller than that of the first material (HTL1). Accordingly, in comparison to the single structure of the first hole transporting layer 512 having only the first material (HTL1), the mixed structure enables to improve the lifetime of blue light emitted from the first stack 510. Also, on assumption that the weight total of the first material (HTL1) and the second material (HTL2) of the first hole transporting layer 512 is 100wt%, the first material (HTL1) is within a range from 80wt% to 90wt%, and the second material (HTL2) is within a range from 10wt% to 20wt%. In this case, it is possible to lower the progressive driving voltage of the OLED apparatus 1000, in comparison to the structure having the excessively-large amount of the second material (HTL2) in the first hole transporting layer 512.

FIG. 4A is a graph showing the lifetime of the OLED apparatus in accordance with the weight ratio of the organic material to the inorganic material included in the hole injecting layer. FIG. 4B is a graph showing the progressive driving voltage of the OLED apparatus in accordance with the weight ratio of the organic material to the inorganic material included in the hole injecting layer. FIG. 5 is another graph showing the lifetime of the OLED apparatus in accordance with the weight ratio of the organic material to the inorganic material included in the hole injecting layer.

In detail, FIG. 4A and FIG. 5 are the graphs showing the lifetime of the blue light emitted from the first stack 510 of the OLED apparatus 1000 in accordance with the weight ratio of the organic material to the inorganic material

included in the hole injecting layer 511 when the first hole transporting layer 512 of the OLED apparatus 1000 shown in FIGs. 1 and 2 is formed in the mixed structure. FIG. 4B is the graph showing the progressive driving voltage of the OLED apparatus 1000 in accordance with the weight ratio of the organic material to the inorganic material included in the hole injecting layer 511 when the first hole transporting layer 512 of the OLED apparatus 1000 shown in FIGs. 1 and 2 is formed in the mixed structure. In this case, the hole injecting layer 511 of the OLED apparatus 1000 described with FIGs. 1 and 2 is formed of the mixed-layer structure including rubrene of the organic material and magnesium fluoride ($MgF_2$) of the inorganic material.

Referring to FIG. 4A, if the weight ratio of rubrene to magnesium fluoride ($MgF_2$) included in the hole injecting layer 511 is at 30wt% : 70wt%, the time consumed until the luminance (L) is reduced to 95% in comparison to the initial luminance (Lo) is about 185hrs.

Meanwhile, if the weight ratio of rubrene to magnesium fluoride ($MgF_2$) included in the hole injecting layer 511 is at 50wt% : 50wt%, that is, the weight amount of the organic material is the same as the weight amount of the inorganic material, the time consumed until the luminance (L) is reduced to 95% in comparison to the initial luminance (Lo) is about 230hrs, that is, it is increased to about 124%, in comparison to the above structure in which the weight ratio of rubrene to magnesium fluoride ($MgF_2$) included in the hole injecting layer 511 is at 30wt% : 70wt%, that is, the structure in which the amount of inorganic material is larger than the amount of organic material.

Referring to FIG. 4B, if the weight ratio of rubrene to magnesium fluoride ($MgF_2$) included in the hole injecting layer 511 is at 30wt% : 70wt%, the changed amount of driving voltage after 400hrs from the initial driving voltage, that is, the progressive driving voltage is about 0.85V.

Meanwhile, if the weight ratio of rubrene to magnesium fluoride ($MgF_2$) included in the hole injecting layer 511 is at 50wt% : 50wt%, that is, if the weight amount of the organic material is the same as the weight amount of the inorganic material, the changed amount of driving voltage after 400hrs from the initial driving voltage, that is, the progressive driving voltage is about 0.6V, which is decreased by about 0.25V in comparison to the above structure in which the weight ratio of rubrene to magnesium fluoride ($MgF_2$) included in the hole injecting layer 511 is at 30wt% : 70wt%, that is, the structure in which the amount of inorganic material is larger than the amount of organic material.

Referring to FIG. 5, it is the graph showing the lifetime of the OLED apparatus in accordance with the weight ratio of rubrene to magnesium fluoride ($MgF_2$) included in the hole injecting layer 511. In detail, it is the graph showing the time consumed until the luminance of blue light emitted from the first stack 510 is reduced to about 97% in comparison to the initial luminance in accordance with the weight ratio of rubrene to magnesium fluoride ($MgF_2$) included in the hole injecting layer 511, which is obtained by testing a plurality of manufactured goods, and marking the minimum time, the maximum time and the average time by each condition.

First, as shown in FIG. 5, if the weight ratio of rubrene to magnesium fluoride ($MgF_2$) included in the hole injecting layer 511 is at 80wt% : 20wt%, the time consumed until the luminance of blue light emitted from the first stack 510 is reduced to about 97% in comparison to the initial luminance is 41hrs at minimum, 90hrs at maximum, and 58hrs on the average.

Also, if the weight ratio of rubrene to magnesium fluoride ($MgF_2$) included in the hole injecting layer 511 is at 30wt% : 70wt%, the time consumed until the luminance of blue light emitted from the first stack 510 is reduced to about 97% in comparison to the initial luminance is 55hrs at minimum, 80hrs at maximum, and 68hrs on the average.

If the weight ratio of rubrene to magnesium fluoride ($MgF_2$) included in the hole injecting layer 511 is at 60wt% : 40wt%, the time consumed until the luminance of blue light emitted from the first stack 510 is reduced to about 97% in comparison to the initial luminance is 100hrs at minimum, 140hrs at maximum, and 113hrs on the average.

If the weight ratio of rubrene to magnesium fluoride ($MgF_2$) included in the hole injecting layer 511 is at 40wt% : 60wt%, the time consumed until the luminance of blue light emitted from the first stack 510 is reduced to about 97% in comparison to the initial luminance is 99hrs at minimum, 130hrs at maximum, and 112hrs on the average.

If the weight ratio of rubrene to magnesium fluoride ($MgF_2$) included in the hole injecting layer 511 is at 50wt% : 50wt%, the time consumed until the luminance of blue light emitted from the first stack 510 is reduced to about 97% in comparison to the initial luminance is 105hrs at minimum, 166hrs at maximum, and 124hrs on the average.

That is, referring to FIGs. 4A, 4B and 5, in case of the OLED apparatus 1000 including the first hole transporting layer 512 having the mixed structure according to one embodiment of the present disclosure, on assumption that a weight of the inorganic material included in the hole injecting layer 511 is 'A', and a weight of the organic material included in the hole injecting layer 511 is 'B', if 'A' and 'B' satisfy one of the following Equations (1) to (3):

[Equation (1)] $$B>A \text{ and } A\geq 2/3\times B,$$

[Equation (2)] $$A>B \text{ and } B\geq 2/3\times A,$$

and

$$\text{[Equation (3)]} \qquad A=B,$$

the balance of holes and electrons in the first stack 510 is maintained so that it is possible to improve the lifetime of blue light emitted from the first stack 510. In other words, on assumption that the total weight of the inorganic material and the organic material included in the hole injecting layer 511 is 100wt%, the organic material is within a range from 40wt% to 60wt%, and the inorganic material is within a range from 40wt% to 60wt%. In this case, it is possible to optimize the energy level and hole mobility between the anode 400 and the hole injecting layer 511, whereby it is possible to improve the lifetime of light emitted from the first stack 510 disposed closest to the anode 400, and also to minimize the change of the driving voltage in the OLED apparatus 1000 in accordance with the lapse of time.

As described above, in case of the OLED apparatus 1000 according to the claims, it is possible to improve the lifetime and progressive driving voltage properties of the OLED apparatus 1000 by providing the first hole transporting layer 512 having the mixed structure including the two materials with different hole mobilities, and optimizing the hole mobility and the weight ratio of the two materials. In addition, it is possible to optimize the charge balance in the first emission layer 513, and to optimize the energy level between the hole injecting layer 511 and the anode 400 by adjusting the weight ratio of the organic material to the inorganic material included in the hole injecting layer 511 disposed between the anode 400 and the first hole transporting layer 512 of the mixed structure, to thereby improve the lifetime of the OLED apparatus 1000, and to reduce the change of the driving voltage in accordance with the lapse of time.

According to one embodiment of the present disclosure, the hole transporting layer of the OLED apparatus is formed in the mixed structure including the first material, and the second material whose hole mobility is smaller than that of the first material, so that it is possible to maintain the balance of holes and electrons, thereby improving the lifetime of the OLED apparatus.

Also, it is possible to improve the lifetime and progressive driving voltage properties of the OLED apparatus by optimizing the hole mobility of the first material, the hole mobility of the second material, and the weight ratio of the first material to the second material in the hole transporting layer of the mixed structure.

Also, it is possible to optimize the charge balance in the emission layer, and the energy level between the anode and the hole injecting layer by adjusting the weight ratio of the organic material to the inorganic material included in the hole injecting layer disposed in contact with the hole transporting layer of the mixed structure, to thereby improve the lifetime of the OLED apparatus, and to lower the progressive driving voltage.

According to one embodiment of the present disclosure, an organic light emitting display (OLED) apparatus according to the claims comprises an anode, a cathode, and a plurality of stacks, wherein, among the plurality of stacks, the first stack closest the anode includes a first emission layer consisting of a blue emission layer; and a hole transporting layer having a first material, and a second material whose hole mobility is smaller than that of the first material.

The hole mobility of the second material may be 1 / 10 of the hole mobility of the first material or less than 1 / 10 of the hole mobility of the first material.

On assumption that a total weight of the first material and the second material may be 100wt%, the first material is within a range from 80wt% to 90wt%, and/or the second material may be within a range from 10wt% to 20wt%.

The first material may include any one among $\alpha$-NPD, TCTA, TPD, TPB, TPAC, m-TPEE, FTPD, (NDA)PP, TRP, PPD, and OPT1.

The second material is an organic compound including a spirofluorene group.

The first stack may further include a hole injecting layer between the hole transporting layer and the anode. The hole injecting layer may be a mixed layer including an organic material and an inorganic material.

On assumption that a total weight of the organic material and the inorganic material is 100wt%, the organic material may be within a range from 40wt% to 60wt%, and the inorganic material is within a range from 40wt% to 60wt%.

The organic material may include or may be rubrene. The inorganic material may include or may be magnesium fluoride ($MgF_2$).

The OLED apparatus according to the claims further comprise a second stack having a second emission layer between the first stack and the cathode. The second emission layer include any one of a yellow-green emission layer and a green emission layer, and/or a red emission layer.

The OLED apparatus according to the claims further comprise a third stack having a third emission layer between the second stack and the cathode. The third emission layer consists of a blue emission layer.

According to another embodiment of the present disclosure, an organic light emitting display (OLED) apparatus according to the claims comprises a blue emission layer, a hole transporting layer, and a hole injecting layer between an anode and a cathode, wherein the hole transporting layer is formed in a mixed structure having two materials with different hole mobilities, and the hole injecting layer includes an organic material and an inorganic material, and, on assumption that a weight of the inorganic material included in the hole injecting layer is 'A', and a weight of the organic

material included in the hole injecting layer is 'B', 'A' and 'B' satisfy one of the following Equations (1) to (3):

$$\text{[Equation (1)]} \qquad B>A \text{ and } A\geq 2/3\times B,$$

$$\text{[Equation (2)]} \qquad A>B \text{ and } B\geq 2/3\times A, \text{ and}$$

$$\text{[Equation (3)]} \qquad A=B.$$

The hole transporting layer may be formed in the mixed structure including a first material, and a second material with a hole mobility is smaller than that of the first material.

The hole mobility of the second material may be 1 / 10 of the hole mobility of the first material or less than 1 / 10 of the hole mobility of the first material.

On assumption that a total weight of the first material and the second material is 100wt%, the first material may be within a range from 80wt% to 90wt%, and/or the second material may be within a range from 10wt% to 20wt%.

The first material may include any one among $\alpha$-NPD, TCTA, TPD, TPB, TPAC, m-TPEE, FTPD, (NDA)PP, TRP, PPD, and OPT1. The second material is an organic compound including a spirofluorene group.

The organic material may be rubrene. The inorganic material may be magnesium fluoride ($MgF_2$).

The anode, the hole injecting layer, the hole transporting layer, and the blue emission layer may be provided in a sequential contact structure. That is, the hole transporting layer may be formed on the hole injecting layer and the hole injecting layer may be formed on the anode. Also, the first emission layer, in particular the blue emission layer of the first emission layer, may be formed on the hole transporting layer.

## Claims

1. An organic light emitting display (OLED) apparatus comprising:

   an anode (400), a cathode (600), and a plurality of stacks (510, 520, 530) disposed therebetween and stacked one above another,
   wherein, among the plurality of stacks (510, 520, 530), a first stack (510) closest the anode (400) includes:

      a hole transporting layer (512) including a first material, and a second material, the hole mobility of the second material being smaller than that of the first material, and wherein the second material is an organic compound including a spirofluorene group,
      a first emission layer (513) consisting of a blue emission layer as the only emission layer of the first stack, wherein the first emission layer (511) is positioned on the hole transporting layer (512),
      wherein, among the plurality of stacks (510, 520, 530), a second stack (520) is positioned between the first stack (510) and the cathode (600), and the second stack (520) includes a second emission layer (523) consisting of any one of a yellow-green emission layer and a green emission layer, and/or a red emission layer as the only emission layer of the second stack,
      wherein, among the plurality of stacks (510, 520, 530), a third stack (530) is positioned between the second stack (520) and the cathode (600) and the third stack includes a third emission layer (533) consisting of a blue emission layer as the only emission layer of the third stack.

2. The OLED apparatus according to claim 1, wherein the hole mobility of the second material is 1 / 10 or less of the hole mobility of the first material.

3. The OLED apparatus according to claim 1 or 2, wherein, on assumption that a total weight of the first material and the second material is 100wt% of the hole transporting layer (512),
   the first material is within a range from 80wt% to 90wt%, and/or the second material is within a range from 10wt% to 20wt%.

4. The OLED apparatus according to any one of the preceding claims, wherein the first material includes at least one of N,N'-bis(naphthalene-1-yl)-N,N'-bis(phenyl)-2,2'-dimethylbenzidine (a-NPD), 4,4',4"-tris(carbazol-9-yl)triphenylamine (TCTA), N,N'-bis(3-methylpneyl)-N,N'-bis(phenyl)-benzidine (TPD), tetra-N-phenylbenzidine (TPB), 1,1-bis(4-di-p-tolylaminophenyl)-cyclohexane (TPtrgAC), m-TPEE, fluorinatedtriphenyldiamine (FTPD), TRP, p-phenylenediamine (PPD), and OPT1, wherein
'm-TPEE' is a compound expressed by the following Chemical Formula 1,

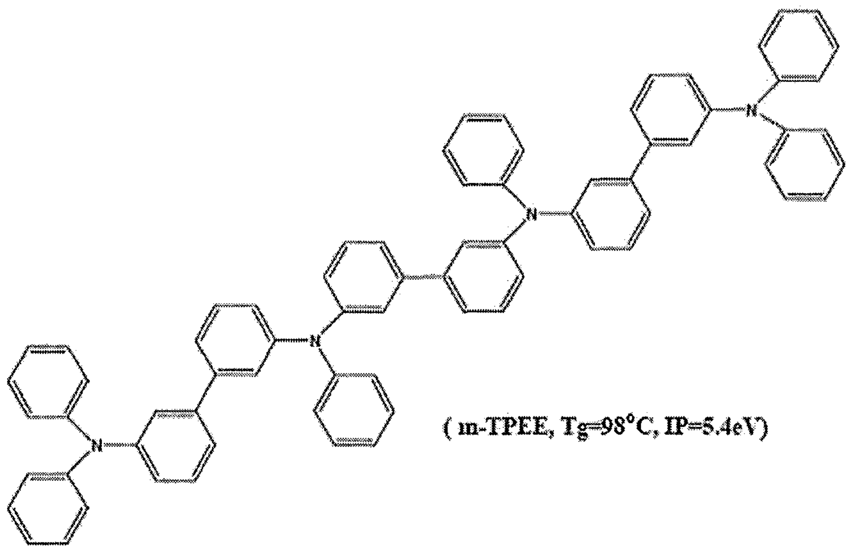


Chemical Formula 1

'TRP' is a compound expressed by the following Chemical Formula 2,

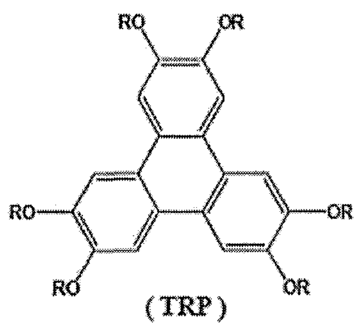


Chemical Formula 2

and, 'OPT1' is a compound expressed by the following Chemical Formula 3

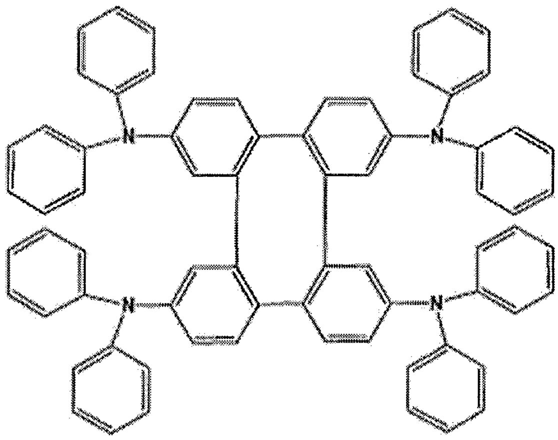

(OPT 1, Tg=147°C)

Chemical Formula 3.

**5.** The OLED apparatus according to any one of the preceding claims,

wherein the first stack (510) further includes a hole injecting layer (511) between the hole transporting layer (512) and the anode (400), and
wherein the hole injecting layer (511) is a mixed layer including an organic material and an inorganic material.

**6.** The OLED apparatus according to claim 5, wherein, on assumption that a total weight of the organic material and the inorganic material is 100wt% in the hole injecting layer (511),
the organic material is within a range from 40wt% to 60wt%, and/or the inorganic material is within a range from 40wt% to 60wt%.

**7.** The OLED apparatus according to claim 5 or 6, wherein the organic material is rubrene, and/or wherein the inorganic material is magnesium fluoride (MgF2).

**8.** The OLED apparatus according to any one of claims 5 to 7, wherein on assumption that a weight of the inorganic material included in the hole injecting layer (511) is 'A', and a weight of the organic material included in the hole injecting layer (511) is 'B', 'A' and 'B' satisfy one of the following Equations (1) to (3):

$$\text{Equation (1) } B>A \text{ and } A\geq 2/3\times B,$$

$$\text{Equation (2) } A>B \text{ and } B\geq 2/3\times A,$$

and

$$\text{Equation (3) } A=B.$$

**9.** The OLED apparatus according to any one of claims 5 to 8, wherein the hole transporting layer (512) is positioned on the hole injecting layer (511), and the hole injecting layer (511) is positioned on the anode (400).

**Patentansprüche**

**1.** Organische lichtemittierende Anzeige- (OLED) Vorrichtung, umfassend:

eine Anode (400), eine Kathode (600) und eine Vielzahl von Stapeln (510, 520, 530), die dazwischen angeordnet und übereinander gestapelt sind,

wobei unter der Vielzahl von Stapeln (510, 520, 530) ein erster Stapel (510), der der Anode (400) am nächsten ist, aufweist:

eine Lochtransportschicht (512), die ein erstes Material und ein zweites Material aufweist, wobei die Lochbeweglichkeit des zweiten Materials geringer ist als die des ersten Materials, und wobei das zweite Material eine organische Verbindung ist, die eine Spirofluorengruppe aufweist,
eine erste Emissionsschicht (513), die aus einer blauen Emissionsschicht als einzige Emissionsschicht des ersten Stapels besteht, wobei die erste Emissionsschicht (511) auf der Lochtransportschicht (512) positioniert ist,
wobei unter der Vielzahl von Stapeln (510, 520, 530) ein zweiter Stapel (520) zwischen dem ersten Stapel (510) und der Kathode (600) positioniert ist und der zweite Stapel (520) eine zweite Emissionsschicht (523) aufweist, die aus einer gelb-grünen Emissionsschicht oder einer grünen Emissionsschicht und/oder einer roten Emissionsschicht als einzige Emissionsschicht des zweiten Stapels besteht,
wobei unter der Vielzahl von Stapeln (510, 520, 530) ein dritter Stapel (530) zwischen dem zweiten Stapel (520) und der Kathode (600) positioniert ist und der dritte Stapel eine dritte Emissionsschicht (533) aufweist, die aus einer blauen Emissionsschicht als einzige Emissionsschicht des dritten Stapels besteht.

**2.** OLED-Vorrichtung nach Anspruch 1, wobei die Lochbeweglichkeit des zweiten Materials 1 / 10 oder weniger der Lochbeweglichkeit des ersten Materials beträgt.

**3.** OLED-Vorrichtung nach Anspruch 1 oder 2, wobei unter der Annahme, dass ein Gesamtgewicht des ersten Materials und des zweiten Materials 100 Gew.-% der Lochtransportschicht (512) beträgt,
das erste Material in einem Bereich von 80 Gew.-% bis 90 Gew.-% liegt und/oder das zweite Material in einem Bereich von 10 Gew.-% bis 20 Gew.-% liegt.

**4.** OLED-Vorrichtung nach einem der vorstehenden Ansprüche, wobei das erste Material mindestens eines von N,N'-Bis(naphthalin-1-yl)-N,N'-Bis(phenyl)-2,2'-dimethylbenzidin (α-NPD), 4,4',4"-Tris(carbazol-9-yl)triphenylamin (TCTA), N,N'-Bis(3-methylpneyl)-N,N'-bis(phenyl)-benzidin (TPD), Tetra-N-phenylbenzidin (TPB), 1,1-Bis(4-di-p-tolylaminophenyl)-cyclohexan (TPtrgAC), m-TPEE, fluoriertes Triphenyldiamin (FTPD), TRP, p-Phenylendiamin (PPD) und OPT1, wobei
'm-TPEE' eine Verbindung ist, die durch die folgende chemische Formel 1 ausgedrückt wird,

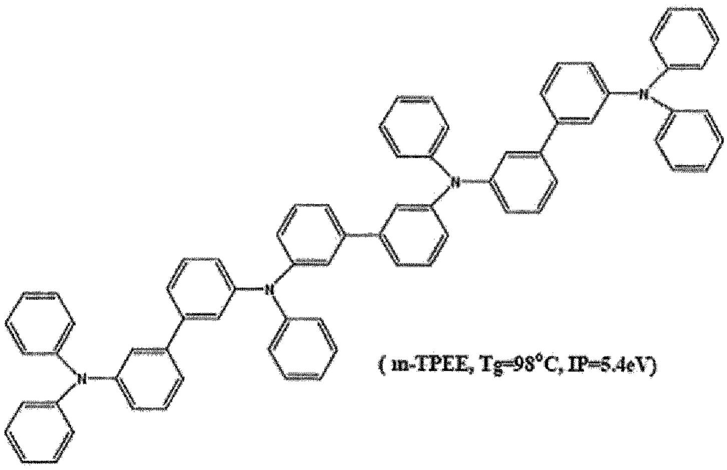

( m-TPEE, Tg=98°C, IP=5.4eV)

Chemische Formel 1

'TRP' eine Verbindung ist, die durch die folgende chemische Formel 2 ausgedrückt wird,

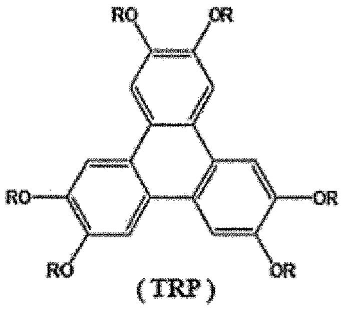

(TRP)

Chemische Formel 2

und 'OPT1' eine Verbindung ist, die durch die folgende chemische Formel 3 ausgedrückt wird

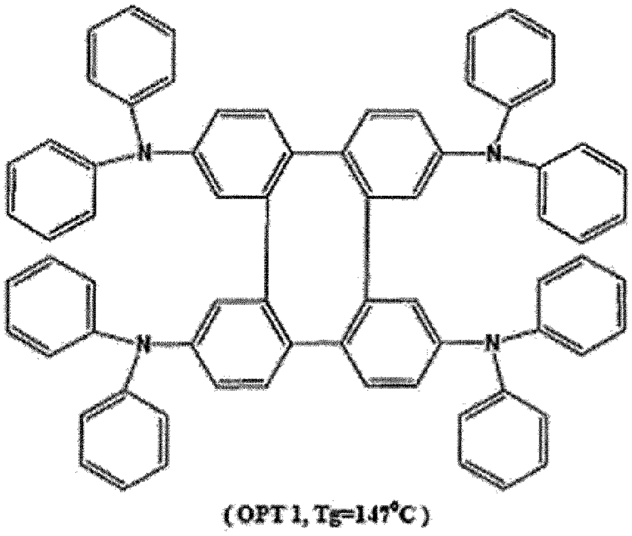

(OPT 1, $T_g$=147°C)

Chemische Formel 3.

**5.** OLED-Vorrichtung nach einem der vorstehenden Ansprüche,

wobei der erste Stapel (510) weiter eine Lochinjektionsschicht (511) zwischen der Lochtransportschicht (512) und der Anode (400) aufweist, und
wobei die Lochinjektionsschicht (511) eine Mischschicht ist, die ein organisches Material und ein anorganisches Material aufweist.

**6.** OLED-Vorrichtung nach Anspruch 5, wobei unter der Annahme, dass ein Gesamtgewicht des organischen Materials und des anorganischen Materials in der Lochinjektionsschicht (511) 100 Gew.-% beträgt,
das organische Material innerhalb eines Bereichs von 40 Gew.-% bis 60 Gew.-% liegt und/oder das anorganische Material innerhalb eines Bereichs von 40 Gew.-% bis 60 Gew.-% liegt.

**7.** OLED-Vorrichtung nach Anspruch 5 oder 6, wobei das organische Material Rubren ist und/oder wobei das anorganische Material Magnesiumfluorid (MgF2) ist.

**8.** OLED-Vorrichtung nach einem der Ansprüche 5 bis 7, wobei unter der Annahme, dass ein Gewicht des anorganischen Materials, das in der Lochinjektionsschicht (511) vorhanden ist, 'A' ist und ein Gewicht des organischen Materials, das in der Lochinjektionsschicht (511) vorhanden ist, 'B' ist, 'A' und 'B' eine der folgenden Gleichungen (1) bis (3) erfüllen:

$$\text{Gleichung (1) } B > A \text{ und } A \geq 2/3 \times B,$$

$$\text{Gleichung (2) } A > B \text{ und } B \geq 2/3 \times A,$$

und

$$\text{Gleichung (3) } A = B.$$

**9.** OLED-Vorrichtung nach einem der Ansprüche 5 bis 8, wobei die Lochtransportschicht (512) auf der Lochinjektionsschicht (511) positioniert ist und die Lochinjektionsschicht (511) auf der Anode (400) positioniert ist.

**Revendications**

**1.** Appareil d'affichage électroluminescent organique (OLED) comportant :

une anode (400), une cathode (600) et une pluralité de piles (510, 520, 530) disposées entre celles-ci et empilées les unes au-dessus des autres,
dans lequel, parmi la pluralité de piles (510, 520, 530), une première pile (510) la plus proche de l'anode (400) inclut :

une couche de transport de trous (512) incluant un premier matériau et un second matériau, la mobilité des trous du second matériau étant inférieure à celle du premier matériau, et dans lequel le second matériau est un composé organique incluant un groupe spirofluorène,
une première couche d'émission (513) constituée d'une couche d'émission de bleu en tant que seule couche d'émission de la première pile, dans lequel la première couche d'émission (511) est positionnée sur la couche de transport de trous (512),
dans lequel, parmi la pluralité de piles (510, 520, 530), une deuxième pile (520) est positionnée entre la première pile (510) et la cathode (600), et la deuxième pile (520) inclut une deuxième couche d'émission (523) constituée d'une couche quelconque parmi une couche d'émission de jaune-vert et une couche émission de vert, et/ou une couche d'émission de rouge en tant que seule couche d'émission de la deuxième pile,
dans lequel, parmi la pluralité de piles (510, 520, 530), une troisième pile (530) est positionnée entre la deuxième pile (520) et la cathode (600), et la troisième pile inclut une troisième couche d'émission (533) constituée d'une couche d'émission de bleu en tant que seule couche d'émission de la troisième pile.

**2.** Appareil OLED selon la revendication 1, dans lequel la mobilité des trous du second matériau représente 1/10 ou moins de la mobilité des trous du premier matériau.

**3.** Appareil OLED selon la revendication 1 ou 2, dans lequel, en supposant qu'un poids total du premier matériau et du second matériau représente 100 % en poids de la couche de transport de trous (512),
le premier matériau est dans une plage de 80 % en poids à 90 % en poids, et/ou le second matériau est dans une plage de 10 % en poids à 20 % en poids.

**4.** Appareil OLED selon l'une quelconque des revendications précédentes, dans lequel le premier matériau inclut au moins un élément parmi N,N'-bis(naphthalène-1-yl)-N,N'-bis(phényl)-2,2'-diméthylbenzidine (a-NPD), 4,4',4"-tris(carbazol-9-yl)triphénylamine (TCTA), N,N'-bis(3-méthylphényl)-N,N'-bis(phényl)-benzidine (TPD), tétra-N-phénylbenzidine (TPB), 1,1-bis(4-di-p-tolylaminophényl)-cyclohexane (TPtrgAC), m-TPEE, triphényldiamine fluorée (FTPD), TRP, p-phénylènediamine (PPD) et OPT1, dans lequel
'm-TPEE' est un composé exprimé par la Formule chimique 1 suivante :

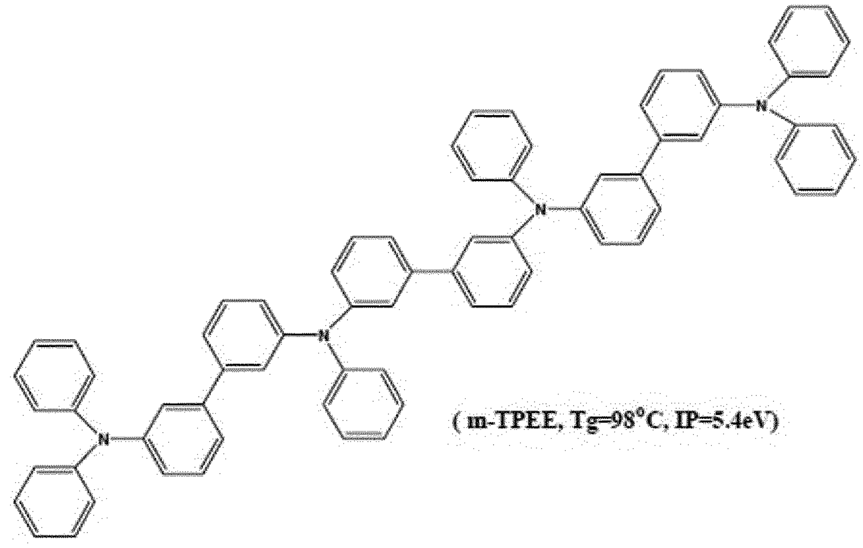

( m-TPEE, Tg=98°C, IP=5.4eV)

Formule chimique 1

'TRP' est un composé exprimé par la Formule chimique 2 suivante :

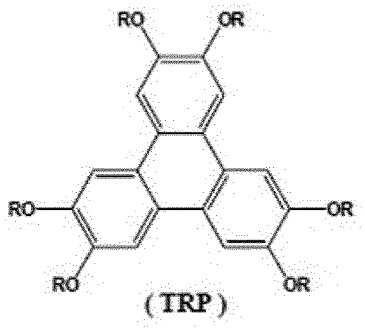

( TRP )

Formule chimique 2

et 'OPT1' est un composé exprimé par la Formule chimique 3 suivante :

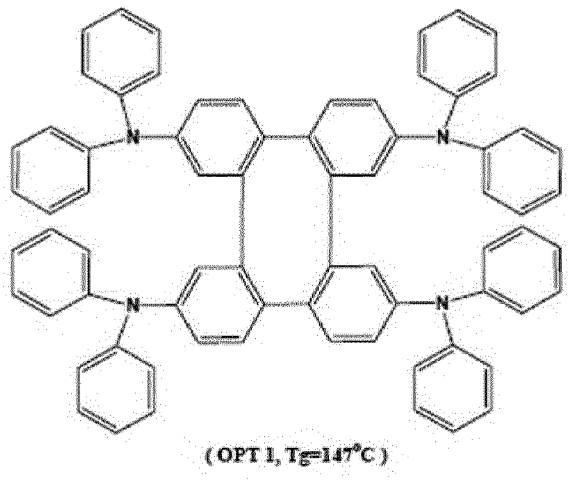

( OPT 1, Tg=147°C )

Formule chimique 3.

**5.** Appareil OLED selon l'une quelconque des revendications précédentes,

dans lequel la première pile (510) inclut en outre une couche d'injection de trous (511) entre la couche de transport de trous (512) et l'anode (400), et
dans lequel la couche d'injection de trous (511) est une couche mixte incluant un matériau organique et un matériau inorganique.

**6.** Appareil OLED selon la revendication 5, dans lequel, en supposant qu'un poids total du matériau organique et du matériau inorganique représente 100 % en poids de la couche d'injection de trous (511),
le matériau organique est dans une plage de 40 % en poids à 60 % en poids, et/ou le matériau inorganique est dans une plage de 40 % en poids à 60 % en poids.

**7.** Appareil OLED selon la revendication 5 ou 6, dans lequel le matériau organique est le rubrène, et/ou dans lequel le matériau inorganique est le fluorure de magnésium ($MgF_2$).

**8.** Appareil OLED selon l'une quelconque des revendications 5 à 7, dans lequel en supposant qu'un poids du matériau inorganique inclus dans la couche d'injection de trous (511) est 'A', et qu'un poids du matériau organique inclus dans la couche d'injection de trous (511) est 'B', 'A' et 'B' satisfont à l'une des Équations (1) à (3) suivantes :

$$\text{Équation (1) : } B > A \text{ et } A \geq 2/3 \times B,$$

$$\text{Équation (2) : } A > B \text{ et } B \geq 2/3 \times A,$$

et

$$\text{Équation (3) : } A = B.$$

**9.** Appareil OLED selon l'une quelconque des revendications 5 à 8, dans lequel la couche de transport de trous (512) est positionnée sur la couche d'injection de trous (511), et la couche d'injection de trous (511) est positionnée sur l'anode (400).

FIG. 1

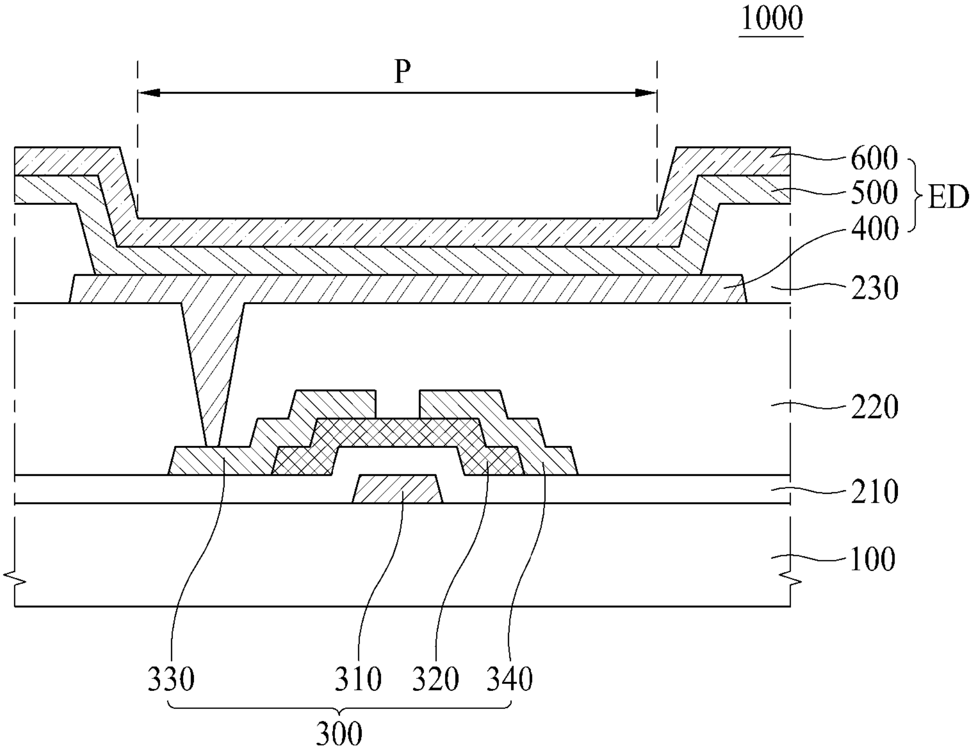

FIG. 2

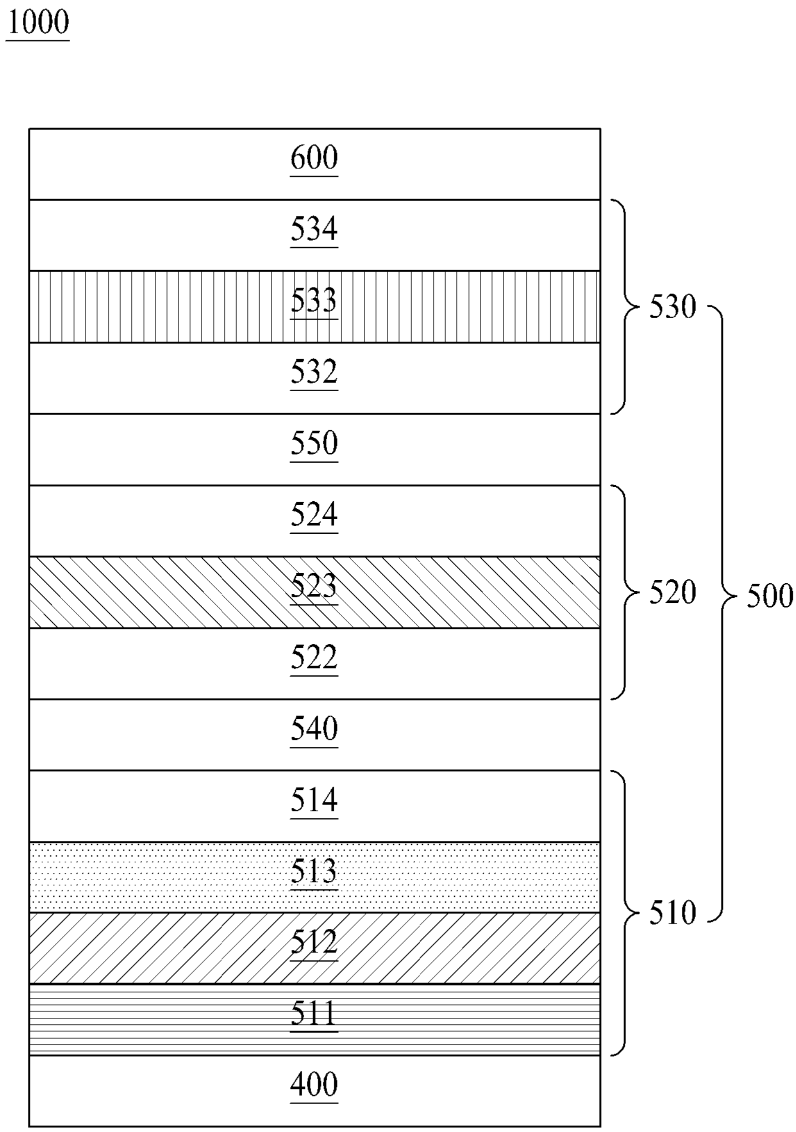
1000
600
534
533
532
550
524
523
522
540
514
513
512
511
400
530
520
510
500

FIG. 3A

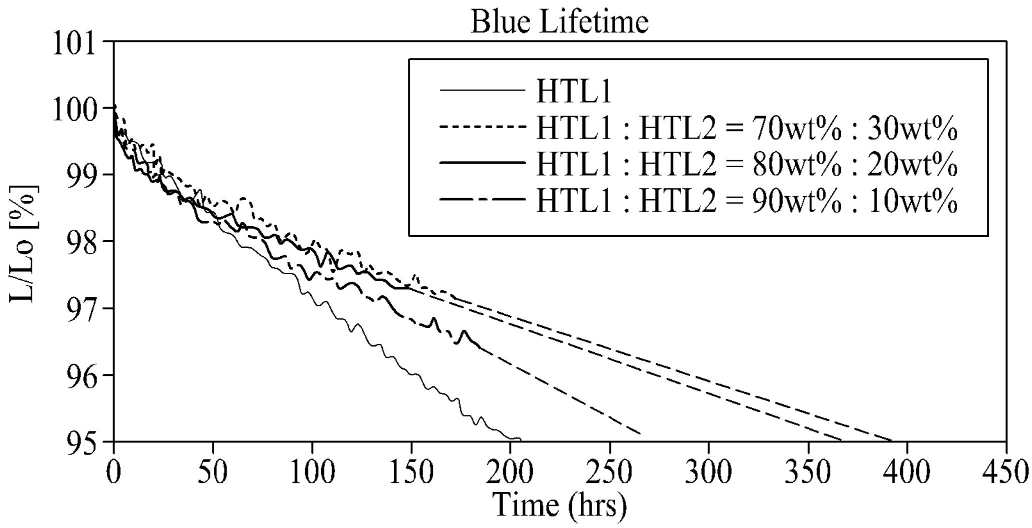
Blue Lifetime
L/Lo [%]
101
100
99
98
97
96
95
HTL1
HTL1 : HTL2 = 70wt% : 30wt%
HTL1 : HTL2 = 80wt% : 20wt%
HTL1 : HTL2 = 90wt% : 10wt%
0
50
100
150
200
250
300
350
400
450
Time (hrs)

FIG. 3B

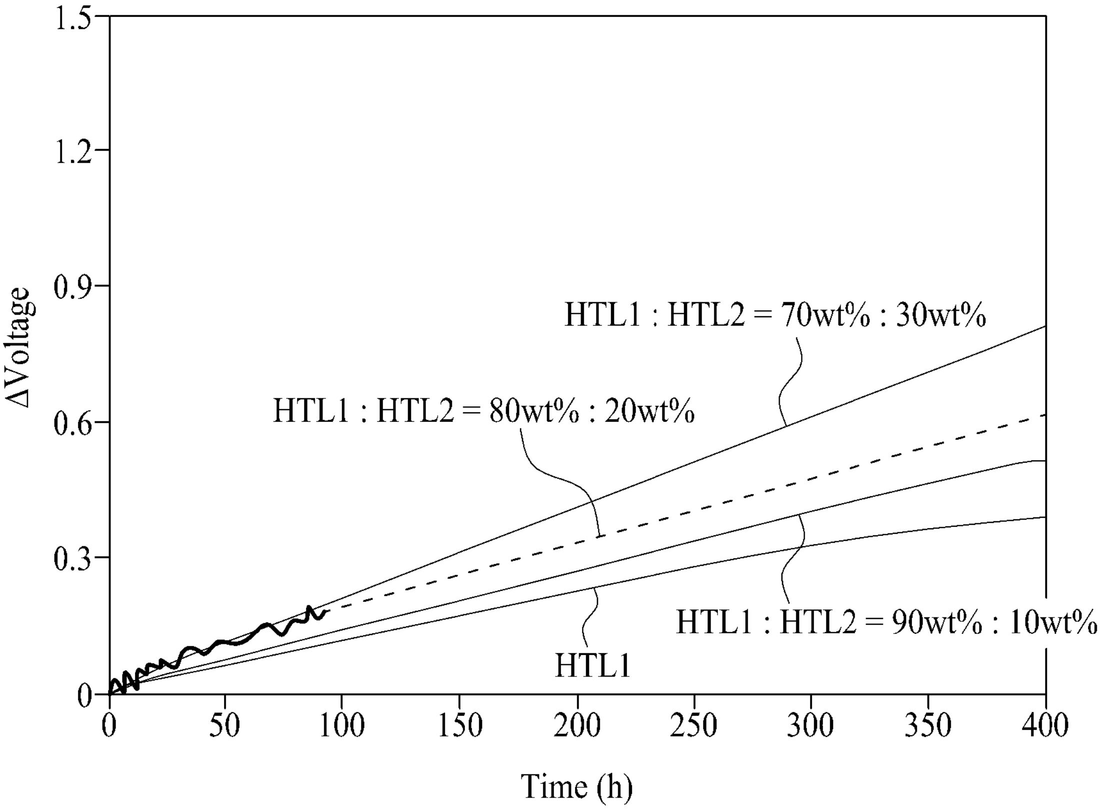
ΔVoltage
1.5
1.2
0.9
0.6
0.3
0
HTL1 : HTL2 = 70wt% : 30wt%
HTL1 : HTL2 = 80wt% : 20wt%
HTL1 : HTL2 = 90wt% : 10wt%
HTL1
0
50
100
150
200
250
300
350
400
Time (h)

FIG. 4A

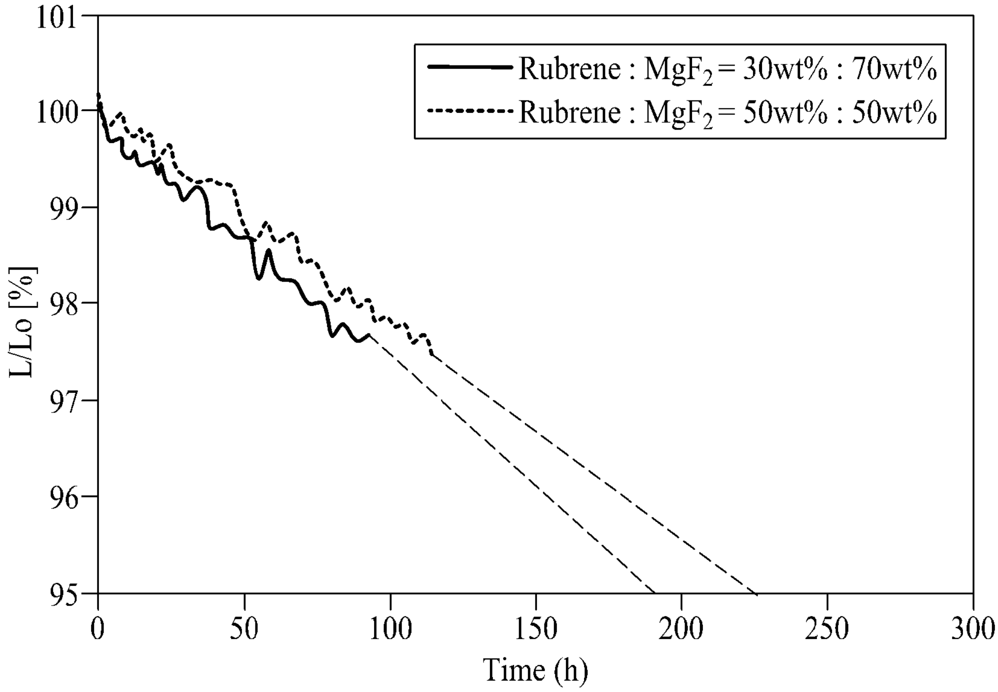
101
100
99
98
97
96
95
L/Lo [%]
0
50
100
150
200
250
300
Time (h)
Rubrene : $MgF_2$ = 30wt% : 70wt%
Rubrene : $MgF_2$ = 50wt% : 50wt%

FIG. 4B

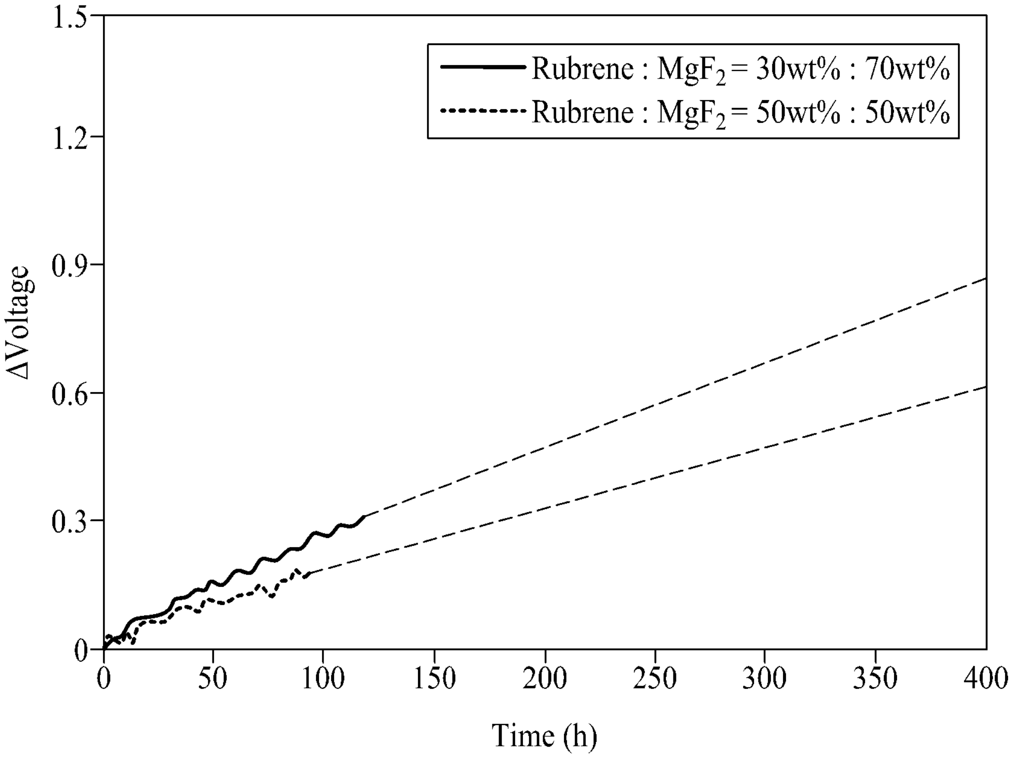
1.5
1.2
0.9
0.6
0.3
0
ΔVoltage
0
50
100
150
200
250
300
350
400
Time (h)
Rubrene : $MgF_2$ = 30wt% : 70wt%
Rubrene : $MgF_2$ = 50wt% : 50wt%

FIG. 5

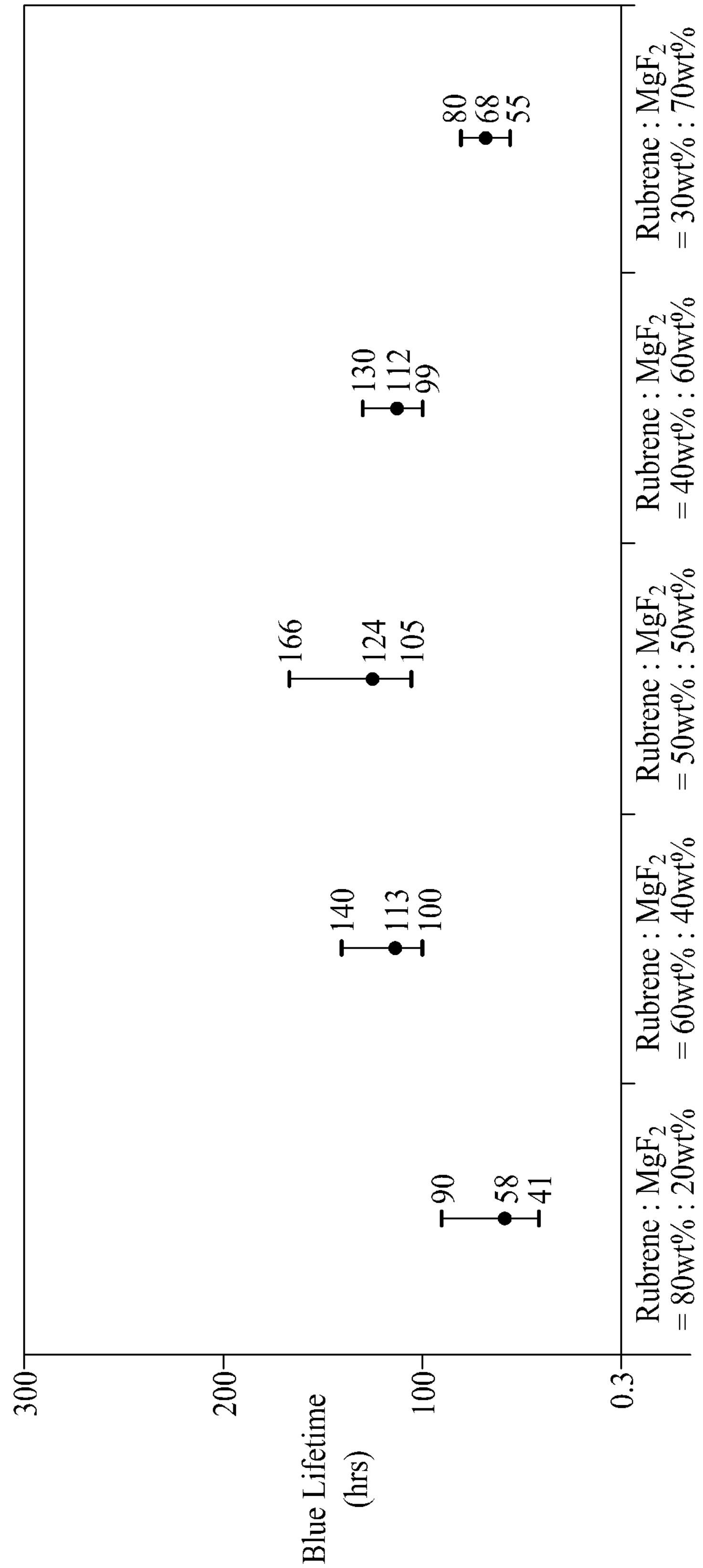
Blue Lifetime (hrs)
300
200
100
0.3
Rubrene : $MgF_2$ = 80wt% : 20wt%
Rubrene : $MgF_2$ = 60wt% : 40wt%
Rubrene : $MgF_2$ = 50wt% : 50wt%
Rubrene : $MgF_2$ = 40wt% : 60wt%
Rubrene : $MgF_2$ = 30wt% : 70wt%
90
58
41
140
113
100
166
124
105
130
112
99
80
68
55

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020150173114
- EP 2204862 A